# EUROPEAN PATENT APPLICATION

(11) **EP 4 546 434 A1**
(43) Date of publication of application: **30.04.2025**
(21) Application number: 23827008.6
(22) Date of filing: 09.06.2023
(51) Int. Cl.: H01L 31/10, H01L 21/306

(54) **METHOD FOR MANUFACTURING LIGHT-RECEIVING ELEMENT**

(30) Priority: 22.06.2022 JP 2022100554
(71) Applicant: Shin-Etsu Handotai Co., Ltd., Tokyo 100-0004 (JP)
(72) Inventor: ISHIZAKI, Junya, Annaka-shi, Gunma 379-0196 (JP); FURUYA, Shogo, Annaka-shi, Gunma 379-0196 (JP)
(74) Representative: Sonnenhauser, Thomas Martin
(86) International application number: PCT/JP2023/021453
(87) International publication number: WO 2023/248821

(57) **Abstract**

The present invention is a method for producing a light-receiving device using an epitaxial wafer in which an InP buffer layer, an InGaAs light absorption layer, and an InP cap layer are grown on an InP substrate, the method including the steps of forming an InGaAs contact layer on the InP cap layer, removing a part of the InGaAs contact layer by a photolithography method to form an InGaAs contact portion, forming a protective film so as to coat the InP cap layer and the InGaAs contact portion, forming an opening pattern portion in a part of the protective film, diffusing an impurity to the opening pattern portion in a phosphorus-containing atmosphere, selectively removing a phosphorus precipitate adhered to a surface in the step of diffusing the impurity using a strong aqueous base, and forming an electrode on the InGaAs contact portion and a back surface of the InP substrate. This provides the method for producing a light-receiving device, in which only a phosphorus precipitate precipitated on a wafer surface can be selectively removed.

## Description

### TECHNICAL FIELD

The present invention relates to a method for producing a light-receiving device.

### BACKGROUND ART

Semiconductor optical devices provided with an n-type semiconductor layer, a light absorption layer, and a p-type semiconductor layer sequentially are widely used. The light absorption layer is an intrinsic layer (intrinsic layer. Also referred to as an i layer or an undoped layer) where no impurities are intentionally added (doped). Such a semiconductor optical device typically has what is known as a PIN structure in which the light absorption layer is sandwiched between the p-type semiconductor layer and the n-type semiconductor layer (Patent Document 1).

### CITATION LIST

### PATENT LITERATURE

Patent Document 1: JP 2009-105105 A

### SUMMARY OF INVENTION

### TECHNICAL PROBLEM

Incidentally, in a production method where an epitaxial wafer having a photodiode (PD) structure is produced using InGaAs/InP-based materials and converted into the PD having a PIN structure (hereinafter may be simply referred to as "PIN-PD") by diffusing impurities, phosphorus may precipitate on a surface of the PIN-PD structure after an impurity diffusion treatment due to diffusion treatment atmosphere. The phosphorus precipitation is prone to be generated when a temperature falling rate is high. The phosphorus precipitate not only hinders light-receiving of the PD, reducing sensitivity but also acts as an ohmic inhibition factor during contact electrode formation; consequently, removal thereof is necessary before the electrode formation.

Before the impurity diffusion, a protective film such as SiO₂, and the like is formed and patterned to expose a semiconductor portion through an opening. The impurity is then diffused through the exposed region to form a P/N junction within the epitaxial wafer. In order to maintain pressure or temperature above phosphorus dissociation pressure during the impurity diffusion, the impurity diffusion treatment is performed while the atmosphere is maintained as a phosphorus-containing atmosphere. After the diffusion treatment, a rapid temperature falling is desirable to prevent excessive diffusion.

However, when the temperature falling rate is high, a wafer surface is cooled down rapidly, and thus phosphorus in the atmosphere is prone to precipitate on the wafer surface. Because of the precipitated phosphorus, a transmittance of light is decreased, resulting in deteriorated light-receiving characteristics of the light-receiving device. Moreover, precipitated phosphorus can also be a factor that increases ohmic resistance when the electrode is formed on the wafer.

In this way, the phosphorus precipitate present on the wafer surface can be a factor that degrades the characteristics of the light-receiving device and needs to be removed. To achieve this, it is necessary to have a method to selectively remove only the phosphorus precipitate without changing the structure of the wafer side. However, a disclosure of a technique for selective etching that removes only the phosphorus precipitate without etching InGaAs and InP that make up the wafer has not been known.

It has been known that hydrochloric acid-based etchant is suitably used for etching only InP, and a mixture solution of hydrogen peroxide water and acid is suitably used for etching only InGaAs. The phosphorus precipitate is an easy-to-etch material and any type of acid can be used for etching. However, there has been no known disclosure of a technique for an etchant that etches only phosphorus precipitate and has selectivity for InP and InGaAs.

The present invention has been made in view of the above-described problem. An object of the present invention is to provide a method for producing a light-receiving device where in the PIN-PD production step using an InGaAs/InP-based material (epitaxial wafer), only phosphorus precipitate precipitated on a wafer surface after impurity diffusion treatment is etched, and through selective etching which minimizes etching of InP and InGaAs, a phosphorus precipitate can be selectively removed.

### SOLUTION TO PROBLEM

To achieve the object, the present invention provides a method for producing a light-receiving device using an epitaxial wafer in which an InP buffer layer, an InGaAs light absorption layer, and an InP cap layer are epitaxially grown sequentially on an InP substrate, the method comprising the steps of:
forming an InGaAs contact layer on the InP cap layer;
removing a part of the InGaAs contact layer by a photolithography method to form an InGaAs contact portion;
forming a protective film so as to coat the InP cap layer and the InGaAs contact portion;
forming an opening pattern portion in a part of the protective film so as to include the InGaAs contact portion;
diffusing an impurity to the opening pattern portion in a phosphorus-containing atmosphere;
selectively removing a phosphorus precipitate adhered to a surface in the step of diffusing the impurity using a strong aqueous base; and
forming an electrode on the InGaAs contact portion and a back surface of the InP substrate.

According to such a method for producing a light-receiving device, in a PIN-PD production step using an InGaAs/InP-based material (epitaxial wafer), phosphorus precipitate precipitated on a wafer surface after impurity diffusion treatment can be selectively removed while limiting etching of InP and InGaAs.

In this event, the impurity can be zinc (Zn) and the protective film can be SiO₂.

With these, it is possible to easily make a p-type conductivity type and easily form the protective film.

In this event, as the strong aqueous base, a solution prepared by dissolving one or more bases selected from tetramethylammonium hydroxide (TMAH), tetraethylammonium hydroxide (TEAH), tetrabutylammonium hydroxide (TBAH), KOH, NaOH, and Ca(OH)₂ in water can be used.

This enables more reliable and stable removal of only the phosphorus precipitate by etching.

In this event, the strong aqueous base having a pH exceeding 12 can be used.

This enables more reliable and stable removal of only the phosphorus precipitate by etching.

### ADVANTAGEOUS EFFECTS OF INVENTION

As described above, according to the inventive method for producing a light-receiving device, in the PIN-PD production step using the InGaAs/InP-based material (epitaxial wafer), the phosphorus precipitate precipitated on the wafer surface after impurity diffusion treatment can be selectively removed while limiting etching of InP and InGaAs. Consequently, the PIN-PD, which is of high quality, can be produced with high yield.

### BRIEF DESCRIPTION OF DRAWINGS

FIG. 1 is a view describing a production step of a light-receiving device.
FIG. 2 shows a production step of a light-receiving device, following FIG. 1.
FIG. 3 shows a production step of a light-receiving device, following FIG. 2.
FIG. 4 shows a production step of a light-receiving device, following FIG. 3.
FIG. 5 shows a result of evaluating a thickness of phosphorus precipitate and a thickness of an InGaAs contact portion as a function of etching time when etching PIN-PD having phosphorus precipitate after impurity diffusion using a strong aqueous base.
FIG. 6 shows a result comparing resistivities in Comparative Example and Example as an investigation of an effect of etching treatment on ohmic contact formation.

### DESCRIPTION OF EMBODIMENTS

Hereinafter, the present invention will be described in detail. However, the present invention is not limited thereto.

As described above, a method for producing a light-receiving device has been desired where in a PIN-PD production step using an InGaAs/InP-based material (epitaxial wafer), only phosphorus precipitate precipitated on a wafer surface after impurity diffusion treatment is etched, and through selective etching which minimizes etching of InP and InGaAs, a phosphorus precipitate can be selectively removed.

To solve the above problem, the present inventors have earnestly studied and found that a method for producing a light-receiving device using an epitaxial wafer in which an InP buffer layer, an InGaAs light absorption layer, and an InP cap layer are epitaxially grown sequentially on an InP substrate, the method includes the steps of forming an InGaAs contact layer on the InP cap layer, removing a part of the InGaAs contact layer by a photolithography method to form an InGaAs contact portion, forming a protective film so as to coat the InP cap layer and the InGaAs contact portion, forming an opening pattern portion in a part of the protective film so as to include the InGaAs contact portion, diffusing an impurity to the opening pattern portion in a phosphorus-containing atmosphere, selectively removing a phosphorus precipitate adhered to a surface in the step of diffusing the impurity using a strong aqueous base, and forming an electrode on the InGaAs contact portion and a back surface of the InP substrate, thereby phosphorus precipitate precipitated on a wafer surface after impurity diffusion treatment can be selectively removed in a PIN-PD production step using an InGaAs/InP-based material (epitaxial wafer), while limiting the etching of InP and InGaAs. This finding has led to the completion of the present invention.

Hereinafter, the description will be given referring to the drawings.

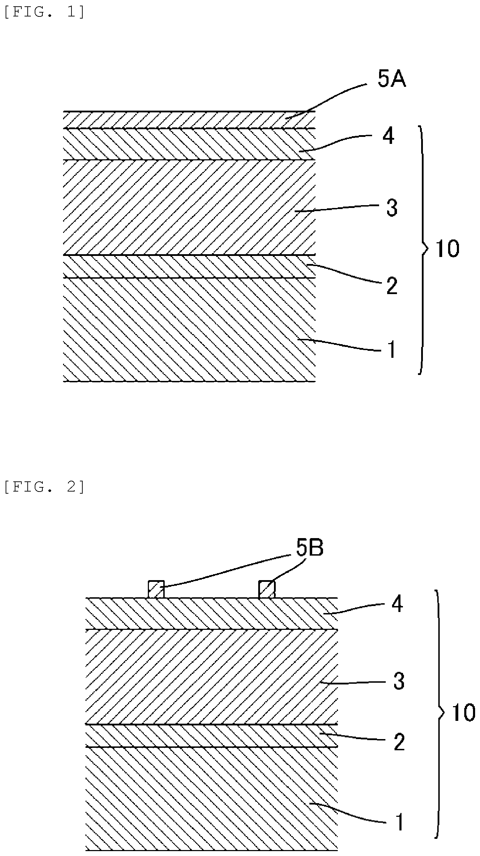

As shown in FIG. 1, a first conductivity type InP substrate 1 is used as a starting substrate, a non-doped InP buffer layer 2 having a thickness of, for example, 1 µm is then stacked; then an InGaAs light absorption layer 3 such as a non-doped InₓGa₁₋ₓAs (0.4 ≤ x ≤ 0.6) having a thickness of, for example, 3 µm, and a non-doped InP cap layer 4 having a thickness of, for example, 1 µm are epitaxially grown in sequence to provide an epitaxial wafer 10.

Moreover, an InGaAs contact layer 5A such as the non-doped InₓGa₁₋ₓAs (0.4 ≤ x ≤ 0.6) having a thickness of, for example, 0.15 µm is epitaxially grown on the InP cap layer 4 to make an epitaxial wafer having a light-receiving device structure, being an epitaxial function layer (Step of forming InGaAs contact layer).

Next, as shown in FIG. 2, a part of the InGaAs contact layer 5A is removed by a photolithography method to form an InGaAs contact portion 5B (Step of forming InGaAs contact portion). When forming a pattern, a sulfuric acid peroxide solution can be used, which etches InGaAs quickly and selectively and has an extremely slow etching rate for the InP layer.

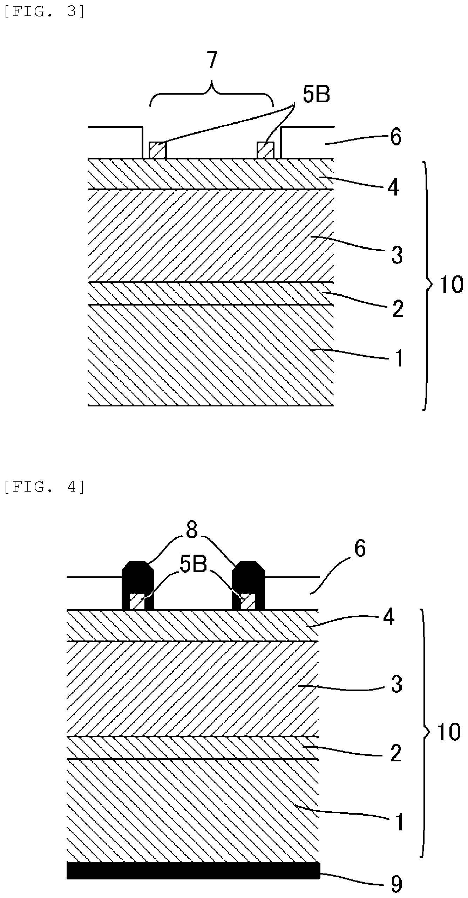

Then, as shown in FIG. 3, after forming the InGaAs contact portion 5B, a protective film 6 composed of SiO₂, and the like is formed on a surface. An opening pattern 7 is formed in a part of the formed protective film and the impurity is diffused in the phosphorus-containing atmosphere to provide a second conductivity type to the opening pattern 7 portion (Step of diffusing impurity). SiO₂ is preferable as the protective film because the formation thereof is relatively easy.

In the step of diffusing the impurity, for example, when diffusing Zn to provide p-type conductivity type, the diffusion treatment is performed by mixing a Zn source gas such as dimethyl zinc (DMZn) while maintaining a temperature of 400°C or higher in the phosphorus-containing atmosphere at normal pressure. Specifically, a phosphine (PH₃) gas flows in an atmosphere where hydrogen (H₂) is a carrier gas to make the phosphorus-containing atmosphere, and partial pressure is maintained at 1×10⁻⁶ [atm] or more. During a temperature rise, the phosphorus-containing atmosphere is maintained, and during a temperature fall, the phosphorus-containing atmosphere is maintained up to 400°C.

After the diffusion treatment, the wafer taken out is immersed in the strong aqueous base (solution containing strong base material) to remove the phosphorus precipitate by etching (Step of selectively removing phosphorus precipitate). By removing the phosphorus precipitate adhered to the wafer surface using the strong aqueous base in this way, the etching of InP and InGaAs is minimized, and only the phosphorus precipitate which is precipitated on the wafer surface after the impurity diffusion treatment can be selectively removed by etching.

The strong base material preferably has a pH exceeding 12 when made into an aqueous solution. In addition, the upper limit of the pH may be, for example, 14 or less (pH ≤ 14). Moreover, for example, tetramethylammonium hydroxide (TMAH), tetraethylammonium hydroxide (TEAH), tetrabutylammonium hydroxide (TBAH), KOH, NaOH, and Ca(OH)₂, and the like can be selected for such strong base materials, and the aqueous solution of one or more base selected from these materials dissolved in water can be used. With such a strong aqueous base, only the phosphorus precipitate can be removed by etching more reliably and stably.

The results of investigating the presence or absence of selectivity in the etchability to the phosphorus precipitate and the etchability to both InGaAs and InP, when the wafer is immersed in an acid-aqueous solution as an etchant in Table 1 and the strong aqueous base as an etchant in Table 2 are shown. The etching selectivity and the etchability of the phosphorus precipitate are confirmed by the following method.

A substrate in which an InP pattern is formed by selectively etching InP using a substrate having an InP/InGaAs, and a substrate in which an InGaAs pattern is formed by selectively etching InGaAs using a substrate having an InGaAs/InP structure are provided to form the phosphorus precipitate on the substrate surfaces by the diffusion treatment. These substrates are immersed in various types of etchants. When the selective etchability to the phosphorus precipitate is present, a thickness or size of the patterned InP layer portion or InGaAs layer portion is unchanged but only the phosphorus precipitate is disappeared. In this case, it is determined that "etching selectivity is present" (etching selectivity: good). On the other hand, when the thickness or size of the InP layer portion or InGaAs layer portion is changed, it is determined that "etching selectivity is absent" (etching selectivity: poor). Note that when the etching selectivity to InGaAs is present, and the etching selectivity to InP is absent, it is also determined that "etching selectivity is absent" (etching selectivity: poor). The same is true in the opposite case. Moreover, when the patterned InP portion or the InGaAs layer portion is etched, the etching selectivity is absent; however, the phosphorus precipitate is removed together with a base layer (InP layer portion or InGaAs layer portion) and the phosphorus precipitate itself is eliminated, it is defined as "removed" (phosphorus precipitate: good).

As shown in Table 1, it is found that acid etchants have the etchability to the phosphorus precipitate (phosphorus precipitate: good); however, the etching rate of InGaAs or InP is not slow relative to the etching rate of the phosphorus precipitate, resulting in the etching selectivity being almost absent (etching selectivity: poor).

**[Table 1]**

| | Hydrochlori c Acid | Sulfuri c Acid | Phosphori c Acid | Hydrofluori c Acid | Aceti c Acid | Citri c Acid | Maloni c Acid | NH₃ |
|---|---|---|---|---|---|---|---|---|
| Phosphorus precipitat e | Good | Good | Good | Good | Good | Good | Good | Goo d |
| Etching Selectivity | Poor | Poor | Poor | Poor | Poor | Poor | Poor | Poo r |

As shown in Table 2, it is found that when strong base etchants are used, the etching progresses to the phosphorus precipitate (phosphorus precipitate: good) but the etching rate of InGaAs or InP is slow and the etching selectivity is high (etching selectivity: good).

**[Table 2]**

| | TMAH | TEAH | TBAH | KOH | NaOH | Ca (OH)₂ |
|---|---|---|---|---|---|---|
| Phosphorus precipitate | Good | Good | Good | Good | Good | Good |
| Etching Selectivity | Good | Good | Good | Good | Good | Good |

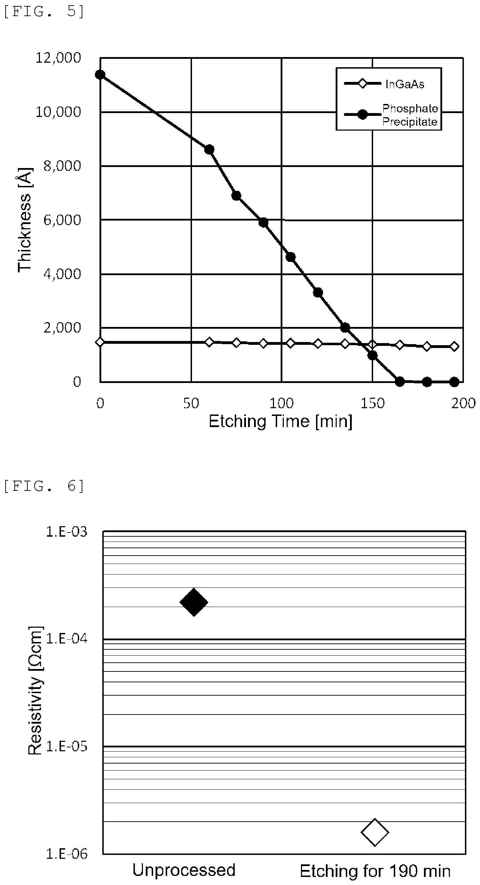

Moreover, FIG. 5 shows a plot of the thickness of the phosphorus precipitate and the thickness of the InGaAs contact portion relative to the etching time when 2.38% TMAH aqueous solution is used as the etchant for removing the phosphorus precipitate to PIN-PD after impurity diffusion. The thickness of the phosphorus precipitate is measured by processing the cross-sectional shape after treatment and performing SEM observation. Moreover, in the case of a thin film, a TEM sample is produced to observe. While the thickness of the phosphorus precipitate is monotonously decreasing, the thickness of the InGaAs portion is almost constant. Although not shown in the drawings, even in an etching evaluation of the InP layer alone, the etching to the InP layer is extremely minimal, equivalent to or less than that of the InGaAs. It is indicated that by using the strong aqueous base such as TMAH, the phosphorus precipitate is selectively etched, and the InGaAs and InP are almost not etched. In addition, it is preferable that TMAH has a concentration of 0.5% or more. The other aqueous solutions containing strong base materials are preferably capable of maintaining a pH exceeding 12, and any concentration can be selected.

After the step of selectively removing the phosphorus precipitate, as shown in FIG. 4, an electrode 8 is formed on the InGaAs contact portion in the opening pattern 7 portion. An electrode 9 is also formed on a back surface of the InP substrate 1 to produce the light-receiving device (Step of forming electrode).

### EXAMPLE

Hereinafter, the present invention will be specifically described with reference to Example. However, the present invention is not limited thereto.

### (Example)

An n-type InP substrate was used as a starting substrate, and a non-doped InP buffer layer having a thickness of 1 µm was then stacked, then an epitaxial wafer was provided in which a non-doped In_{0.5}Ga_{0.5}As light absorption layer having a thickness of 3 µm, and a non-doped InP cap layer having a thickness of 1 µm were sequentially grown. A non-doped In_{0.5}Ga_{0.5}As contact layer having a thickness of 0.15 µm was formed on the InP cap layer to provide an epitaxial wafer having a light-receiving device structure, being an epitaxial function layer (FIG. 1).

A part of the In_{0.5}Ga_{0.5}As contact layer was removed by a photolithography method to form an InGaAs contact portion. A sulfuric acid peroxide solution was used to form a pattern (FIG. 2).

After forming the In_{0.5}Ga_{0.5}As contact portion, a SiO₂ film was formed on a surface as a protective film. An opening pattern was formed in a part of the formed SiO₂ film and Zn was diffused in the opening pattern portion (FIG. 3). The diffusion of Zn was performed in a phosphorus-containing atmosphere at normal pressure while maintaining a temperature of 400°C or higher, using hydrogen (H₂) as a carrier gas while flowing a phosphine (PH₃) gas to produce the phosphorus-containing atmosphere, and maintaining a partial pressure of the PH₃ gas at 1×10⁻⁶ [atm] or more. A diffusion treatment was performed by mixing a dimethyl zinc (DMZn) gas therein. During temperature rise, the phosphorus-containing atmosphere was maintained, and during temperature fall, the phosphorus-containing atmosphere was maintained up to 400°C.

After the diffusion treatment, the wafer taken out was immersed in tetramethylammonium hydroxide (TMAH) aqueous solution having a concentration of 2.38% and pH 13 for 190 minutes to etch a phosphorus precipitate. Subsequently, an electrode was formed on the InGaAs contact portion in the opening pattern portion, and further, an electrode was also formed on a back surface of the n-type InP substrate to produce the light-receiving device (FIG. 4).

### (Comparative Example)

A light-receiving device was produced under the same conditions as Example except that the step of etching a phosphorus precipitate by immersing in tetramethylammonium hydroxide (TMAH) aqueous solution was not performed.

FIG. 6 shows data comparing resistivity in a case where an electrode was formed on an unprocessed wafer (Comparative Example) and resistivity in a case where an electrode was formed on a wafer that had been etching-processed for 190 minutes by TMAH (Example). While the resistance in Comparative Example (unprocessed product) was high, it was found that the resistance in Example (etching processed product) was lower by approximately two orders of magnitude. This indicates that due to the removal of the phosphorus precipitate by etching, the phosphorus precipitate, which was a hindrance when forming ohmic contact, was removed, in addition, a shape, including a thickness of a contact layer, was almost unchanged even after the selective removal treatment to the phosphorus precipitate, indicating that the etching treatment did not adversely affect the formation of ohmic contact.

As described above, according to Example of the present invention, it was found that it is possible to selectively remove the phosphorus precipitate by treatment with a strong aqueous base and that an underlying epitaxial layer is not adversely affected when performing removal.

The present description includes the following embodiments.
[1]: A method for producing a light-receiving device using an epitaxial wafer in which an InP buffer layer, an InGaAs light absorption layer, and an InP cap layer are epitaxially grown sequentially on an InP substrate, the method comprising the steps of:
   forming an InGaAs contact layer on the InP cap layer;
   removing a part of the InGaAs contact layer by a photolithography method to form an InGaAs contact portion;
   forming a protective film so as to coat the InP cap layer and the InGaAs contact portion;
   forming an opening pattern portion in a part of the protective film so as to include the InGaAs contact portion;
   diffusing an impurity to the opening pattern portion in a phosphorus-containing atmosphere;
   selectively removing a phosphorus precipitate adhered to a surface in the step of diffusing the impurity using a strong aqueous base; and
   forming an electrode on the InGaAs contact portion and a back surface of the InP substrate.
[2]: The method for producing a light-receiving device of the above [1], wherein
   the impurity is zinc (Zn) and the protective film is SiO₂.
[3]: The method for producing a light-receiving device of the above [1] or [2], wherein
   as the strong aqueous base, a solution prepared by dissolving one or more bases selected from tetramethylammonium hydroxide (TMAH), tetraethylammonium hydroxide (TEAH), tetrabutylammonium hydroxide (TBAH), KOH, NaOH, and Ca(OH)₂ in water is used.
[4]: The method for producing a light-receiving device of the above [1], [2] or [3], wherein
   the strong aqueous base having a pH exceeding 12 is used.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing a light-receiving device using an epitaxial wafer in which an InP buffer layer, an InGaAs light absorption layer, and an InP cap layer are epitaxially grown sequentially on an InP substrate, the method comprising the steps of:
forming an InGaAs contact layer on the InP cap layer;
removing a part of the InGaAs contact layer by a photolithography method to form an InGaAs contact portion;
forming a protective film so as to coat the InP cap layer and the InGaAs contact portion;
forming an opening pattern portion in a part of the protective film so as to include the InGaAs contact portion;
diffusing an impurity to the opening pattern portion in a phosphorus-containing atmosphere;
selectively removing a phosphorus precipitate adhered to a surface in the step of diffusing the impurity using a strong aqueous base; and
forming an electrode on the InGaAs contact portion and a back surface of the InP substrate.

2. The method for producing a light-receiving device according to claim 1, wherein
the impurity is zinc (Zn) and the protective film is SiO₂.

3. The method for producing a light-receiving device according to claim 1, wherein
as the strong aqueous base, a solution prepared by dissolving one or more bases selected from tetramethylammonium hydroxide (TMAH), tetraethylammonium hydroxide (TEAH), tetrabutylammonium hydroxide (TBAH), KOH, NaOH, and Ca(OH)₂ in water is used.

4. The method for producing a light-receiving device according to claim 2, wherein
as the strong aqueous base, a solution prepared by dissolving one or more bases selected from tetramethylammonium hydroxide (TMAH), tetraethylammonium hydroxide (TEAH), tetrabutylammonium hydroxide (TBAH), KOH, NaOH, and Ca(OH)₂ in water is used.

5. The method for producing a light-receiving device according to any one of claims 1 to 4, wherein
the strong aqueous base having a pH exceeding 12 is used.
